# EUROPEAN PATENT APPLICATION

(11) **EP 3 988 318 A1**
(43) Date of publication of application: **27.04.2022**
(21) Application number: 20826371.5
(22) Date of filing: 18.06.2020
(51) Int. Cl.: B41N 1/14, B41C 1/10, G03F 7/00, G03F 7/09, G03F 7/11

(54) **WATERLESS PLANOGRAPHIC PRINTING ORIGINAL PLATE AND METHOD FOR PRODUCING WATERLESS PLANOGRAPHIC PRINTING PLATE USING SAME**

(30) Priority: 20.06.2019 JP 2019114384
(71) Applicant: Toray Industries, Inc., Tokyo, 103-8666 (JP)
(72) Inventor: ICHIKAWA Michihiko, Okazaki-shi, Aichi 444-8522 (JP); KUBO Yoshihiko, Okazaki-shi, Aichi 444-8522 (JP); TSUJI Akihiro, Tokyo 103-8666 (JP); HATA Takahiro, Tokyo 103-8666 (JP)
(74) Representative: Kador & Partner PartG mbB
(86) International application number: PCT/JP2020/023935
(87) International publication number: WO 2020/256059

(57) **Abstract**

The invention provides a waterless offset lithographic printing plate precursor that is mountable on a magnet type printing cylinder and has high durability and halftone dot reproducibility. The waterless offset lithographic printing plate precursor contains at least a heat-sensitive layer and a silicone rubber layer disposed on a substrate, the substrate being of a ferromagnet material.

## Description

### TECHNICAL FIELD

The present invention relates to a waterless offset lithographic printing plate precursor and a method for producing a waterless lithographic printing plate using the precursor.

### BACKGROUND ART

For curved surface printing on, for example, the bodies of cylindrical containers such as tubes and two-piece cans including beverage cans and aerosol cans, combinations of a printing plate and a blanket designed for receiving an ink layer from the printing plate and transferring it onto the body of a can have been generally used, and a resin letterpress printing plate or a waterless offset printing plate is normally adopted as the printing plate. In the case of printing on two-piece cans, the use of a printing method based on a resin letterpress printing plate, namely, the letterpress dry offset method, is the mainstream, and such a resin letterpress printing plate carries a photosensitive layer that forms submillimeter to millimeter level uneven relief on a highly durable iron substrate to realize mass printing at high speed. However, it has been difficult to realize sufficient printing quality due to fattening of image areas and halftone dots to cause collapse of characters and halftone dot images, and smaller numbers of AM screen lines of about 120 lines/inch in halftone dots to increase the visibility of individual dots, leading to grainy halftone dot images and conspicuous striped patterns or rosette patterns due to interference of halftone dots.

In recent years, furthermore, there is a market environment where demand for high-definition and highly decorative beverage cans for sales promotion is increasing, and a waterless offset lithographic printing plate designed for printing on two-piece cans having a laser heat-sensitive layer located between an aluminum substrate and a silicone rubber layer is proposed (Patent Document 1).

### PRIOR ART DOCUMENTS

### PATENT DOCUMENTS

Patent document 1: Japanese Unexamined Patent Publication (Kokai) No. 2018-58257

### SUMMARY OF INVENTION

### PROBLEMS TO BE SOLVED BY THE INVENTION

For the conventional letterpress dry offset method, as described above, it has been difficult to realize sufficient printing quality due to fattening of image areas and halftone dots to cause collapse of characters and halftone dot images, and smaller numbers of AM screen lines of about 120 lines/inch in halftone dots to increase the visibility of individual dots, leading to grainy halftone dot images and conspicuous striped patterns or rosette patterns due to interference of halftone dots.

Furthermore, the majority of such printing machines for two-piece cans have been developed on the premise of using resin letterpress printing plates that are suitable for high-speed mass printing. Such a resin letterpress printing plate has a high-strength iron substrate to ensure durability and accordingly, most printing machines have magnet type printing cylinders to hold the plates of the printing machines, thereby allowing them to secure the iron substrates easily and strongly. A magnet type printing cylinder does not need clamps for securing both ends of a mechanical plate and accordingly, it cannot hold a waterless offset lithographic printing plate having an aluminum substrate, that is, a diamagnetic metal substrate. If aluminum substrate type waterless offset lithographic printing plates are introduced for printing on two-piece cans, therefore, there is the disadvantage that it is necessary to newly procure clamp type printing cylinders for eight colors for one printing machine.

In addition, aluminum substrates generally used for lithographic printing are produced of high-purity aluminum material to ensure increased recyclability at customer print shops. Since high-purity aluminum material is soft and can be scraped easily, there is the disadvantage that printing plates tend to be deformed or abraded easily during high speed printing, that is, the printing plates are insufficient in durability.

Thus, to solve the problem, the major object to be achieved by the present invention is to provide a waterless offset lithographic printing plate precursor that can be mounted on a magnet type printing cylinder, has high durability, and serves for high-definition printing.

### MEANS OF SOLVING THE PROBLEMS

To solve the above problem and achieve the object, the inventors made intensive studies and found that a waterless lithographic printing plate precursor having a ferromagnetic substrate can be mounted on a magnet type plate cylinder, has excellent durability, and enables high-definition printing.
More specifically, the present invention provides a waterless offset lithographic printing plate precursor characterized by having at least a heat-sensitive layer and a silicone rubber layer on a substrate, wherein the substrate is of a ferromagnetic material.

### ADVANTAGEOUS EFFECTS OF THE INVENTION

The waterless offset lithographic printing plate precursor according to the present invention can achieve advantageous effects, that is, it can be mounted on a magnet type printing cylinder, has high durability, and realize improved halftone dot reproducibility.

### DESCRIPTION OF PREFERRED EMBODIMENTS

### (Waterless offset lithographic printing plate precursor)

The waterless offset lithographic printing plate precursor according to the present invention has at least a heat-sensitive layer and a silicone rubber layer on a ferromagnetic substrate. For the waterless offset lithographic printing plate precursor according to the present invention, a laser beam is applied to a portion where an image area (inked portion) in the precursor is to be formed to cause heat generation in the heat-sensitive layer so that the interface between the heat-sensitive layer and the silicone rubber layer becomes brittle, thereby allowing the portion deprived of the silicone rubber layer to be left as an image area. The silicone rubber layer may be covered with a cover film to protect the silicone rubber layer, but it should be peeled and removed before the development step where an image area is formed.

### [Silicone rubber layer]

For the waterless offset lithographic printing plate precursor according to the present invention, the silicone rubber layer has an ink repellent property and it is preferably a silicone rubber layer containing crosslinked polyorganosiloxane. In particular, it is preferably a layer produced by applying an addition reaction type silicone rubber layer composition or a condensation reaction type silicone rubber layer composition or applying a solution of such a composition followed by drying.

The thickness of the silicone rubber layer is preferably 1.0 to 20.0 µm, more preferably 2.0 to 8.0 µm, and most preferably 3.0 to 5.0 µm. If the thickness is 1.0 µm or more, the layer will have a printing durability required for printing, whereas if the thickness is 20.0 µm or less, it will be possible to remove the silicone rubber layer from the laser-exposed portion. If to be applied to printing on two-piece cans, the silicone rubber layer preferably has a weight based thickness in the range of 3.4 to 10.0 g/m², more preferably in the range of 3.6 to 8.0 g/m², to ensure a durability required to perform printing on at least 200,000 cans and allow the formation of high-definition patterns. In the present description, the weight based thickness of a silicone rubber layer means the weight (g) of 1 m² of the silicone rubber layer.

It is preferable for the addition reaction type silicone rubber layer composition to include at least a vinyl group-containing organopolysiloxane, a SiH group-containing compound having a plurality of hydrosilyl groups (hereinafter referred to as addition reaction type crosslinking agent), and a curing catalyst. In addition, a reaction inhibitor may also be contained.

A vinyl group-containing organopolysiloxane has a structure represented by the following general formula (I) as main chain, and has a vinyl group at an end of the main chain or in the interior of the main chain. Here, "having a vinyl group in the interior of the main chain" means that the silicon atom or a carbon atom forming the main chain has a vinyl group. In particular, it is preferable that a vinyl group exist at an end of the main chain. Two or more of such vinyl group-cantaining organosiloxane may be contained together.

-(SiR¹R²-O-)ₙ- (I)

In the general formula (I), n is an integer of 2 or higher. R¹ and R² are each a saturated or unsaturated hydrocarbon group having 1 to 50 carbon atoms. Each hydrocarbon group may be linear, branched, or cyclic and may contain an aromatic ring. R¹ and R² may be either identical to or different from each other. The plurality of R^{1'}s present in a polysiloxane chain as represented by the general formula (I) may be identical to or different from each other. Similarly, the plurality of R^{2'}s present in a polysiloxane chain as represented by the general formula (I) may be identical to or different from each other. From the viewpoint of ink repellency of printing plates, it is preferable that methyl groups account for 50% or more of all groups in the R¹ and R² in the general formula (I). From the viewpoint of handleability, ink repellency of printing plates, and scratch resistance, it is preferable that the weight average molecular weight of the vinyl group-containing organopolysiloxane is 10,000 to 600,000.

Examples of SiH group-containing compounds include organohydrogen polysiloxanes and organic polymers having a diorganohydrogen silyl group, of which organohydrogen polysiloxanes are preferred. Two or more of such compounds may be contained together.

From the viewpoint of curability in forming a silicone rubber layer, the content of the SiH group-containing compound is preferably 0.5 mass% or more, more preferably 1 mass% or more, in the silicone rubber layer composition. On the other hand, it is preferably 20 mass% or less, more preferably 15 mass% or less, from the viewpoint of easiness of controlling the curing rate.

Useful reaction inhibitors include nitrogen-containing compounds, phosphorus based compounds, and unsaturated alcohols, and in particular, acetylene group-containing alcohols are preferred. Two or more thereof may be contained together. If such a reaction inhibitor is contained, it will serve to control the curing rate of the silicone rubber layer. From the viewpoint of the stability of the silicone rubber layer composition or its solution, the content of the reaction inhibitor is preferably 0.01 mass% or more, more preferably 0.1 mass% or more, in the silicone rubber layer composition. On the other hand, from the viewpoint of the curability of the silicone rubber layer, the content is preferably 20 mass% or less, more preferably 15 mass%% or less, in the silicone rubber layer composition.

An appropriate curing catalyst may be selected from generally known ones. It is preferable to use platinum based compounds, and specific examples thereof include platinum, platinum chloride, chloroplatinic acid, olefin-coordinated platinum, alcohol-modified complexes of platinum, and methylvinylpolysiloxane complexes of platinum. Two or more thereof may be contained together. From the viewpoint of the curability of the silicone rubber layer, the content of the curing catalyst is preferably 0.001 mass% or more, more preferably 0.01 mass% or more, in the silicone rubber layer composition. On the other hand, from the viewpoint of the stability of the silicone rubber layer composition or its solution, the content is preferably 20 mass% or less, more preferably 15 mass%% or less, in the silicone rubber layer composition.

In addition to these components, it may also contain a hydroxyl group-containing organopolysiloxane, a hydrolyzable functional group-containing silane, a siloxane containing such a functional group, an ordinary filler such as silica for improving rubber strength, and an ordinary silane coupling agent for improving adhesiveness. Preferred examples of the silane coupling agent include alkoxysilanes, acetoxysilanes, and ketoxiiminosilanes, and it is preferable that a vinyl group or an allyl group is directly bonded to the silicon atom.

It is preferable for the condensation reaction type silicone rubber layer composition to be formed from at least a hydroxyl group-containing organopolysiloxane, a crosslinking agent, and a curing catalyst as raw materials.

A hydroxyl group-containing organopolysiloxane has a structure represented by the above general formula (I), and has a hydroxyl group at an end of the main chain or in the interior of the main chain. Here, "having a hydroxyl group in the interior of the main chain" means that the silicon atom or a carbon atom forming the main chain has a hydroxyl group. In particular, it is preferable for them to have a hydroxyl group at an end of the main chain. Two or more thereof may be contained together.

Examples of the crosslinking agent to be added in a condensation reaction type silicone rubber layer composition include acetic acid-eliminating type, oxime-eliminating type, alcohol-eliminating type, acetone-eliminating type, amide-eliminating type, and hydroxylamine-eliminating type silicon compounds as represented by the following general formula (II).

(R³)₄₋ₘSiXₘ (II)

In the formula, m is an integer of 2 to 4, and R^{3'}s, which may be identical to or different from each other, each represent a substituted or unsubstituted alkyl group having 1 or more carbon atoms, an alkenyl group, an aryl group, or a group in the form of a combination thereof. X's, which may be identical to or different from each other, each represent a hydrolyzable group. Examples of the hydrolyzable group include acyloxy groups (acetic acid-eliminating type) such as acetoxy group, ketoxyimino groups (oxime-eliminating type) such as methylethyl ketoxyimino group, alkoxy groups (alcohol-eliminating type) such as methoxy group, ethoxy group, propoxy group, and butoxy group, alkenyloxy groups (alcohol-eliminating type) such as isopropenoxy group, acylalkylamino groups (amide-eliminating type) such as acetylethylamino group, aminoxy groups (hydroxylamine-eliminating type) such as dimethylaminoxy group. In the above formula, m, which represents the number of hydrolyzable groups, is preferably 3 or 4.

In particular, from the viewpoint of the cuing rate and handleability of silicone rubber layers, acetoxysilanes and ketoxyiminosilanes are preferred, and more specifically, their examples include methyl triacetoxysilane, ethyl triacetoxysilane, tetraacetoxysilane, phenyl tris-(methylethyl ketoxyimino)silane, vinyl tris-(methylethyl ketoxyimino)silane, and tetrakis-(methylethyl ketoxyimino)silane, of which two or more may be contained together.

If such a crosslinking agent is combined with a hydroxyl group-containing organopolysiloxane, the crosslinking agent can be reacted with the silanol group to form an organosiloxane in which the crosslinking agent is bonded instead of the silanol group. When using a condensation reaction type silicone rubber layer composition, therefore, there may be cases where organosiloxanes in which crosslinking agents are bonded exist whereas organosiloxanes having silanol groups do not exist.

From the viewpoint of the stability of the silicone rubber layer composition or its solution, the content of the crosslinking agent in a condensation reaction type silicone rubber layer composition is preferably 0.5 mass% or more, more preferably 1 mass% or more, in the silicone rubber layer composition. On the other hand, from the viewpoint of strength of the silicone rubber layer and scratch resistance of the printing plate, its content is preferably 20 mass% or less, more preferably 15 mass%% less, in the silicone rubber layer composition.

Examples of the curing catalyst to be added in a condensation reaction type silicone rubber layer composition include organic carboxylic acids, other acids, alkalis, amines, metal alkoxides, metal diketonates, and organic acid salts of metals such as tin, lead, zinc, iron, cobalt, calcium, and manganese. More specifically, examples include dibutyltin diacetate, dibutyltin dioctate, dibutyltin dilaurate, zinc octylate, and iron octylate. Two or more thereof may be contained together.

From the viewpoint of the curability and adhesiveness of the silicone rubber layer, the content of the curing catalyst in a condensation reaction type silicone rubber layer composition is preferably 0.001 mass% or more, more preferably 0.01 mass% or more, in the silicone rubber layer composition. On the other hand, from the viewpoint of the stability of the silicone rubber layer composition or its solution, the content is preferably 15 mass% or less, more preferably 10 mass% or less, in the silicone rubber layer composition.

It may be effective to add an ink repellent liquid (having a boiling point of 150°C or more at 1 atm) with the aim of improving the ink repellency of the silicone rubber layer. When the plate surface is pressurized at the time of printing, the ink repellent liquid is pushed to the surface of the ink repellent layer to help the removal of the ink, thereby enhancing the ink repellency. If having a boiling point of 150°C or more, the ink repellent liquid will not be volatilized during the production of waterless offset lithographic printing plate precursors and the effect of ink repellency brought about by its addition will not be decreased. The boiling point referred to herein is the temperature at which the liquid undergoes a decrease in mass of 0.5 mass% or more after being left to stand for 1 hour in an environment under 1 atm. In other words, this liquid undergoes a decrease in mass of less than 0.5 mass% when left to stand for 1 hour in an environment at 150°C under 1 atm. In such cases, the effect of ink repellency brought about by the addition of this liquid will not be decreased significantly.

The ink repellent liquid is preferably a silicone compound, and more preferably a silicone oil. For the present invention, the silicone oil refers to a free polysiloxane component that is not involved in the crosslinks in the ink repellent layer. The molecular weight of such a silicone oil can be measured by gel permeation chromatography (GPC) using polystyrene as reference, and it preferably has a weight average molecular weight Mw of 1,000 to 100,000.

### [Heat-sensitive layer]

As the heat-sensitive layer applied to the waterless offset lithographic printing plate precursor according to the present invention, any heat-sensitive layer that has been used in the conventional waterless offset lithographic printing plate precursor can be adopted. Specifically, a suitable example is a heat-sensitive layer containing at least (a) a photothermal converter, (b) a metal chelate compound, (c) an active hydrogen-containing compound, and (d) a binder resin. It is preferable for such a heat-sensitive layer to have a crosslinked structure formed of a metal chelate compound (b) and an active hydrogen-containing compound (c) in advance before being exposed to laser beams. This serves to decrease the adhesive strength between the heat-sensitive layer and the silicone rubber layer in the laser-exposed portion so that the silicone rubber layer in the laser-exposed portion is removed in a subsequent treatment step to provide a negative type waterless offset lithographic printing plate.

### <Photothermal converter (a)>

There are no specific limitations on the photothermal converter (a) as long as it absorbs laser beams. In regard to the wavelength, the laser beam in use may be in any of the ultraviolet region, the visible region, and the infrared region, and a photothermal converter having an absorption region suited to the wavelength of the laser beam in use may be appropriately selected and adopted. Carbon black can be used particularly suitably. Dyes that absorb infrared rays or near-infrared rays can also be used as photothermal converters, and dyes with a maximum absorption wavelength in the range of 700 to 1,200 nm can be used suitably. It is more preferable to use a dye having a maximum absorption wavelength in the range of 700 to 900 nm. It is preferable for these photothermal converters to account for 0.1 to 40 mass%, more preferably 0.5 to 25 mass% relative to the total mass of the composition present in the heat-sensitive layer.

### <Metal chelate compound (b)>

Examples of the metal chelate compound (b) include metal diketonate, metal alcoxide, alkyl metals, metal carboxylates, metal oxide chelate compounds, metal complexes, and heterometal chelate compounds. Of the metal chelate compounds, particularly preferred compounds include acetyl acetonate (pentanedionate), ethy acetoacetonate (hexanedionate), propyl acetoacetonate (heptanedionate), tetramethyl heptanedionate, and benzoyl acetonate of aluminum, iron(III), or titanium, which may be used singly or in combination of two or more thereof. The content of the metal chelate compound in the heat-sensitive layer is preferably 5 to 300 parts by mass, particularly preferably 10 to 150 parts by mass, relative to 100 parts by mass of the active hydrogen group-containing composition (C) which will be described below.

### <Active hydrogen group-containing composition (C)>

Examples of the active hydrogen group-containing compound (c) include hydroxyl group-containing compounds, amino group-containing compounds, carboxyl group-containing compounds, and thiol group-containing compounds, of which hydroxyl group-containing compounds are preferable. Examples of the hydroxyl group-containing compounds include phenolic hydroxyl group-containing compounds and alcoholic hydroxyl group-containing compounds, epoxy acrylates, epoxy methacrylates, polyvinyl butyral resins, and polymers in which hydroxyl groups are introduced by known methods. The content of the active hydrogen group-containing compound (c) is preferably in the range of 5 to 80 mass%, particularly preferably 20 to 60 mass%, relative to the total mass of the composition present in the heat-sensitive layer.

### <Binder polymer (d)>

There are no specific limitations on the binder polymer (d) as long as it is soluble in organic solvents and can form a film. Specific examples of such a binder polymer that is soluble in organic solvents and can form a film and maintain its morphology include, but not limited to, vinyl polymers, unvulcanized rubbers, polyoxides (polyethers), polyesters, polyurethanes, and polyamides, which may be used singly or as a combination of a plurality thereof. The content of the binder polymer is preferably in the range of 5 to 70 mass%, particularly preferably in the range of 10 to 50 mass%, relative to the total mass of the composition present in the heat-sensitive layer.

### <Others>

Leveling agents, surfactants, dispersing agents, plasticizers, coupling agents, etc. may added appropriately to the heat-sensitive layer. In particular, for ensuring stronger adhesion with the substrate, primer layer, or silicone rubber layer, it is preferable to add various coupling agents, such as silane coupling agent, and unsaturated group-containing compounds. From the viewpoint of printing durability, productivity, etc., the thickness of the heat-sensitive layer is preferably in the range of 0.1 to 10 µm, particularly preferably 1 to 7 µm.

### [Substrate]

A substrate to be used for the waterless offset lithographic printing plate precursor according to the present invention is of a ferromagnetic material and is in the form of a dimensionally stable plate. A substrate of a ferromagnetic material can be applied to a printing cylinder designed for fixation by the action of a magnet, that is, a printing machine equipped with a magnet type printing cylinder, such as the Concord and Rutherford machines (both manufactured by Stolle Machinery Company), which are intended for printing of two-piece cans.

As a substrate material, the ferromagnetic material preferably has a saturation magnetization of 0.3 tesla or more to ensure strong fixation to a magnet type printing cylinder. The saturation magnetization is determined from a magnetization curve measured according to the procedure specified in JIS C 2501: 2019. From the point of view of commercial use, its saturation magnetization is preferably 10 tesla or less. Specifically, preferred materials include iron (2.2 tesla), cobalt (1.8 tesla), nickel (0.6 tesla), alloys thereof, and oxides thereof. In particular, iron, iron oxides, and iron alloys are more preferred because they are low in price and tough. The thickness of the substrate is not particularly limited, but it is preferably in the range of 0.1 to 0.5 mm, more preferably 0.15 mm to 0.32 mm, from the viewpoint of mountability to a printing cylinder, strength, weight, etc. It is also possible to use a substrate composed mainly of a plastic film such as polyester film and a ferromagnetic material layer formed thereon by vapor deposition, plating, etc.

Such a ferromagnetic substrate material preferably has a Rockwell hardness HR30TSm in the range of 50 to 99, more preferably 53 to 80. The Rockwell hardness HR30TSm is determined according to the procedure specified in JIS Z 2245: 2016. If the Rockwell hardness HR30TSm is 60 or more, it is preferable because it serves to prevent the substrate material from being bent or dented when it is detached from a magnet type printing cylinder made of a paramagnetic substance. In general, the Rockwell hardness HR30TSm can be increased by raising the hot rolling temperature or frequency or cold rolling frequency during the substrate sheet production process or increasing the content of carbon. From the viewpoint of commercial use, it is preferably 99 or less, more preferably 80 or less.

It is preferable for a ferromagnetic substrate material to have a yield point Yp in the range of 300 MPa to 2.0 GPa, more preferably in the range of 400 MPa to 1.0 GPa, and still more preferably in the range of 400 to 650 MPa. The yield point Yp can be determined according to the procedure specified in JIS Z 2241: 2011. In the field of printing on two-piece cans, the mainstream method is to use magnet type plate cylinders of paramagnetic material to mount printing plates, and magnet type plate cylinders are adopted in most can manufacturers other than those in Japan because they allow easy mounting of printing plates. For six- to eight-color printing processes that are in mainstream use for printing on two-piece cans, there is the problem of achieving accurate print registration in layering printed patterns of different colors and, as a solution, pins are provided on each magnet type printing cylinder whereas pinholes are provided on each printing plate at positions corresponding to the pins on the printing cylinder. The substrate preferably has a yield point Yp of 300 MPa or more in order to prevent the position of each printing plate from being shifted as the diameters of the pinholes are increased by the printing cylinder rotation force during printing. The yield point Yp can be increased by raising the hot rolling frequency or cold rolling frequency during the substrate sheet production process or performing ageing at higher temperatures. From the viewpoint of commercial use, the yield point Yp is preferably 2.0 GPa or less.

In the case of a PS plate, which is an offset printing plate similar to a waterless offset lithographic printing plate but uses dampening water, an aluminum substrate is adopted and its surface is made porous by graining or anodic oxidation so that it can hold dampening water that repels ink. For example, a PS plate that incorporates an iron substrate is proposed in Japanese Unexamined Patent Publication (Kokai) No. SHO 60-38194, but rust can be caused by dampening water on the iron substrate in a long-term use to cause such problems as deterioration in the dampening water retention function and transfer of rust onto printed products, indicating that iron substrate based PS plates are not practical. On the other hand, a waterless offset lithographic printing plate that has a silicone rubber layer to repel ink does not use dampening water and therefore, it is free from the problem of rust on the iron substrate and can use an iron substrate without practical problems.

For the present invention, a waterless offset lithographic printing plate precursor having a ferromagnetic substrate can be attached to a paramagnetic body having a maximum magnetic force of 0.10 to 1.00 tesla by the action of a magnetic force. In addition, a waterless offset lithographic printing plate can be prepared by forming an image area on such a waterless offset lithographic printing plate precursor mounted on a paramagnetic body having a maximum magnetic force of 0.10 to 1.00 tesla by the action of a magnetic force. Furthermore, such a waterless offset lithographic plate having a ferromagnetic substrate and having an image area formed thereon can be attached to a paramagnetic body having a maximum magnetic force of 0.10 to 1.00 tesla by the action of magnetic force. A paramagnetic body such as a magnet type plate cylinder can serve to strongly fix and mount a ferromagnetic substrate by the action of a magnetic force. The magnet type plate cylinder is a paramagnetic body having a structure in which magnets with strong magnetic forces are embedded in the plate cylinder. Accordingly, the magnetic force differs between the parts containing embedded magnets and the magnet-free parts, but in the part with the maximum magnetic force, which is determined with a Gauss meter, it is preferably 0.10 to 1.00 tesla, more preferably 0.12 to 0.50 tesla, and most preferably 0.14 to 0.30 tesla. Here, to determine the magnetic force in the part having the maximum magnetic force, the entire surface of the magnet type plate cylinder is examined with a Gauss meter to determine the magnetic force in the part where it reaches a maximum. The use of a paramagnetic body with a maximum magnetic force of 0.10 tesla or more is preferred because it serves to allow the waterless offset lithographic printing plate having a ferromagnetic substrate according to the present invention to be firmly fixed even during printing. If the maximum magnetic force is 1.00 tesla or less, it is preferable because it serves to allow the waterless offset lithographic printing plate having a ferromagnetic substrate according to the present invention to be removed from the paramagnetic body without troubles such as bending.

The waterless offset lithographic printing plate precursor according to the present invention has at least a heat-sensitive layer and a silicone rubber layer on a ferromagnetic substrate, and it can be processed into a printable waterless offset lithographic printing plate through an exposure step described later. For both the offset printing plate (lithographic) and the resin letterpress printing plate, the general procedure is to mount a printing plate precursor on an external drum type printing cylinder and apply a laser to draw a shape of the intended image. If the external drum type printing cylinder in the exposure equipment has a paramagnetic body having a maximum magnetic force of 0.10 tesla or more, it is preferable because the waterless offset lithographic printing plate having a ferromagnetic substrate according to the present invention can be firmly fixed without other different type means such as vacuum adsorption.

### [Other layers]

It is preferable for the waterless offset lithographic printing plate precursor according to the present invention to have a primer layer between the substrate and the laser heat-sensitive layer in order to enhance the adhesion between the substrate and the heat-sensitive layer and prevent the heat caused by applied laser beams from leaking into the substrate. Suitable materials for the primer layer include epoxy resin, polyurethane resin, phenol resin, acrylic resin, alkyd resin, polyester resin, polyamide resin, urea resin, and polyvinyl butyral resin. Of these, preferred ones include polyurethane resin, polyester resin, acrylic resin, epoxy resin, and urea resin, which may be used singly or as a mixture of two or more thereof. In addition, additives such as pigments and dyes may be added to the primer layer to ensure improved plate inspection characteristics. The thickness of the primer layer is preferably in the range of 0.5 to 50 µm, particularly preferably 1 to 10 µm. If the thickness of the primer layer is smaller than the above range, it may be impossible to achieve sufficient adhesion or heat insulation attributed to the aforementioned primer layer, whereas if it is larger than the above range, better effects will not be expected and inferior economic effects will result.

The surface of the silicone rubber layer may be covered with a cover film to protect the silicone rubber layer. The cover film is preferably a film that is highly permeable to laser beams, and examples include, but not limited to, polyester film, polypropylene film, polyvinyl alcohol film, saponified ethylene-vinyl acetate copolymer film, polyvinylidene chloride film, and various metal-deposited films.

The waterless offset lithographic printing plate precursor according to the present invention can be used as a printing plate for printing on various printable objects. Such objects for printing include art paper, coated paper, cast-coated paper, synthetic paper, cloth paper, newspaper, aluminized paper, metal, and plastic film. Examples of the plastic film include plastic films of polyethylene terephthalate, polyethylene, polyester, polyamide, polyimide, polystyrene, polypropylene, polycarbonate, polyvinyl acetal, etc.; plastic film-laminated paper formed of paper laminated with a plastic film as listed above; and metallized plastic film formed of plastic film on which metal such as aluminum, zinc, copper, etc., is deposited. Preferred metals include iron and aluminum generally applied to two-piece cans and three-piece cans. In regard to the shapes of printed objects, they can be in the form of web-like coils (continuous sheets), cut sheets for three-piece cans, and tubular cylinders for two-piece cans. Two-piece cans are mainly used for beverage cans and aerosol cans. It is preferable to use it as a waterless offset lithographic printing plate precursor for printing on two-piece cans or printing on tubes, and it is more preferable to use it as a waterless offset lithographic printing plate precursor for printing on two-piece cans, because magnet type cylinders have been widely adopted.

### [Production method for waterless offset lithographic printing plate precursor]

The waterless offset lithographic printing plate precursor according to the present invention can be produced by a conventionally known method, and a suitable method is to apply a heat-sensitive layer composition over a substrate using a common coater such as a reverse roll coater, air knife coater, gravure coater, and die coater, or a rotary coating device etc. and curing it by heating at 50°C to 180°C for an appropriate time, after, if necessary, applying a primer layer composition and curing it by heating at 100°C to 300°C for an appropriate time or by exposure to active light, though other suitable methods may also be available. Next, a silicone rubber layer composition is applied and heated at a temperature of 50°C to 200°C for an appropriate time to form a silicone rubber layer, followed, if necessary, laminating it with a cover film or forming a protective layer, to complete the production process.

### [Production method for waterless offset lithographic printing plate]

The production method for the waterless offset lithographic printing plate according to the present invention includes the following step (1) and step (2):
step (1): a laser beam is applied to a waterless offset lithographic printing plate precursor for printing on two-piece cans according to the present invention, and
step (2): after the step (1), an image area is produced by removing the silicone rubber layer in the portion exposed to laser beams.

A laser beams is applied to a portion of the waterless offset printing precursor where an image area (inked portion) having at least a heat-sensitive layer and a silicone rubber layer on the ferromagnetic substrate in the precursor is to be formed. This works to cause heat generation in the heat-sensitive layer so that the interface between the heat-sensitive layer and the silicone rubber layer becomes brittle. For the present invention, furthermore, a portion deprived of the silicone rubber layer is referred to as an image area. In the case where the silicone rubber layer has a cover film to protect the silicone rubber layer, a laser beam may be applied either through the cover film or after removing the cover film, but it should be peeled and removed before the development step where an image area is formed.

### <Exposure step>

For the production method for the waterless offset lithographic printing plate according to the present invention, laser beam application to a precursor can be performed by a conventionally known method, but a large part of exposure machines for offset printing plates are developed according to aluminum substrate based designs, and therefore, it is necessary to carefully select an appropriate exposure machine. An exposure machine that has a flat movable exposure table and a laser exposure machine capable of scanning in the direction perpendicular to the traveling direction of the exposure table can be used suitably because such a machine can be used for a substrate of any material. Examples of such a laser exposure machine include MultiDX! (a flat table type exposure machine manufactured by Luescher).

If a ferromagnetic substrate of iron, iron oxide, or an iron alloy is adopted, it can be applied to an exposure machine designed for both offset printing plates and resin letterpress plates. An example is FX870II (manufactured by SCREEN Graphic Solutions Co., Ltd.), which has the characteristic feature that an iron substrate can be strongly fixed by means of a magnet type external drum.

When performing exposure to a precursor having a cover film, a laser beam is applied according to the shape of the intended image area after removing the cover film or through the cover film. Various laser sources having oscillation wavelengths in the range of 300 nm to 1,500 nm are useful and available types include argon ion, krypton ion, helium-neon, helium-cadmium, ruby, glass, YAG, titanium doped sapphire, dye, nitrogen, metal vapor, excimer, free electron, and semiconductor, of which semiconductor lasers having emission wavelengths near the near infrared region can be used suitably. It is preferable to use a laser that has a laser oscillator with an output of 1 to 200 W and provides a laser beam with a spot diameter of 5 to 20 µm, and the laser beam scanning speed is preferably in the range of 30 to 1,200 m/min, more preferably in the range of 30 to 800 m/min, although the invention is not limited thereto.

### [Development step]

The silicone rubber layer in the portion exposed to laser beams in the above exposure step can be removed, so that the image area will be developed. Development is preferably carried out by friction treatment in the presence or absence of water or an organic solvent, but it is not limited thereto and can also be realized by the so-called peeling development method in which the cover film is peeled off to form a pattern on the printing plate. For the developing treatment, conventionally known developers can be used and examples include, but not limited to, water, water containing a surface active agent, water containing a polar solvent such as alcohol, ketone, ester, and carboxylic acid, and aliphatic hydrocarbons (hexane, heptane, isoparaffin type hydrocarbons, etc.), aromatic hydrocarbons (toluene, xylene, etc.), halogenated hydrocarbons (trichlene etc.) containing polar solvents.

Development by friction treatment is carried out by rubbing the plate surface in the presence or absence of a developer. Specifically, it is achieved by rubbing the plate surface with nonwoven fabric, absorbent cotton, cloth, sponge, brush, etc., or wiping the plate surface with nonwoven fabric, absorbent cotton, cloth, sponge, etc., that contain a developer.

In addition, the production method for the waterless offset lithographic printing plate according to the present invention preferably includes at least either one of the following the step (i) and the step (ii):
step (i): a pre-treatment step performed before the step (2) in order to treat the laser-exposed portion of the silicone rubber layer to make it brittle, and
step (ii): a post-treatment step performed after the step (2) in order to color the image area deprived of the silicone rubber layer.

Prior to the step (2) for removing the silicone rubber layer, a pre-treatment step (i) for immersing the printing plate in a pre-treatment liquid for an appropriate period may be performed in order to treat the laser-exposed portion of the silicone rubber layer to make it brittle. Examples of such a pre-treatment liquid include water, water containing a polar solvent such as alcohol, ketone, ester, or carboxylic acid, a solution prepared by adding a polar solvent to a solvent containing at least one of aliphatic hydrocarbons, aromatic hydrocarbons, and the like, and polar solvents. In addition, the above pre-treatment liquid may contain a conventionally known surfactant. From the viewpoint of safety, disposal cost, and the like, it is preferable to use a surfactant that forms an aqueous solution having a pH of 5 to 8. The surfactant preferably accounts for 10 mass% or less of the pre-treatment liquid. Such a pre-treatment liquid is very safe and also preferred in terms of economical features such as disposal cost. It is also preferable to use a glycol compound or a glycol ether compound as primary component, and it is more preferable that an amine compound be coexist. Specific examples of such a pre-treatment liquid include CP-Y, CP-X, NP-1, and DP-1 (all manufactured by Toray Industries, Inc.).

Development of a printing plate can also be achieved by carrying out a pre-treatment step in which the printing plate is immersed in a pre-treatment liquid or a developer for an appropriate period to make the laser-exposed portion brittle, followed by rubbing it with a rotating brush in a shower of tap water or by pouring a jet of high pressure water, warm water, or water vapor to the plate surface. In addition, the image area may be colored while developing it by using a developer containing a generally known dye such as Crystal Violet, Victoria Pure Blue, and Astrazone Red, or the development step is followed by a post-treatment step (ii) in which the image area deprived by the silicone rubber layer is colored to highlight the image area. Specific examples of the post-treatment used to color the image area include PA-1 and NA - 1 (both manufactured by Toray Industries, Inc.).

Part or the entirety of the pre-treatment step (i), the step (2) for removing the silicone rubber layer, and the post-treatment step (ii) may be performed automatically by using an automatic developing machine. Useful automatic developing machines include the following: an apparatus containing only a developing unit, an apparatus containing a pre-treatment unit and a developing unit in this order, an apparatus containing a pre-treatment unit, a developing unit, and a post-treatment unit in this order, and an apparatus containing a pre-treatment unit, a developing unit, a post-treatment unit, and a rinsing unit in this order. Specific examples of such automatic developing machines include the TWL-650 series, TWL-860 series, and TWL-1160 series (all manufactured by Toray Industries, Inc.), and an automatic developing machine equipped with a bearer having a curved dent to reduce scratches on the back of the plate as described in Japanese Unexamined Patent Publication (Kokai) No. HEI 5-6000. These may be used in combination.

### [Laminate having at least paramagnetic sheet and ferromagnetic substrate]

Resin letterpress printing plates having a thickness of 0.83 mm are commonly used in printing machines that are equipped with magnet type printing cylinders such as Concord and Rutherford machines (both manufactured by Stolle Machinery Company), which are designed for printing on two-piece cans. A resin letterpress printing plate precursor is composed mainly of a steel substrate with a thickness of 0.23 to 0.25 mm and a photosensitive layer with a thickness of 0.6 mm formed thereon and a printing image relief is produced on the photosensitive layer to provide a printing plate that serves for printing. Compared with this, the waterless offset lithographic printing plate precursor according to the present invention is composed mainly of a ferromagnetic substrate carrying a heat-sensitive layer and a silicone rubber layer, which work as functional layers, formed thereon. Here, these functional layers have thicknesses of the order of a few micrometers and accordingly, the thickness of the ferromagnetic substrate account for nearly the total thickness of the printing plate that is formed by producing a printing image on a precursor. Therefore, from the viewpoint of its mountability on a printing cylinder, strength, weight, etc., it is preferable for the ferromagnetic substrate to have a thickness in the range of 0.1 to 0.5 mm, more preferably 0.15 to 0.32 mm. If the magnet type printing cylinders currently in use to mount resin letterpress printing plates can be directly applied to the waterless offset lithographic printing plate having a ferromagnetic substrate according to the present invention, it allows can manufacturers to cut the cost for purchasing new magnet type printing cylinders. However, compared to the thickness of waterless offset lithographic printing plates, resin letterpress printing plates have larger thickness and accordingly, there will be the problem of correction of the thickness of the waterless offset lithographic printing plates. A low cost method for correcting the thickness of a printing plate is to insert a so-called backing sheet between the waterless offset lithographic printing plate according to the present invention and the magnet type printing cylinder to make it as thick as the resin letterpress printing plate. In the field of commercial printing, however, paper sheets and films that are generally used as backing sheets are diamagnetic and act to reduce the magnetic force of the magnet type printing cylinder, which is paramagnetic, and the waterless offset lithographic printing plate having a ferromagnetic substrate according to the present invention will not be strongly fixed, indicating that such a correction is not practical. To solve this problem, the present invention provides a laminate including at least a paramagnetic sheet and a ferromagnetic substrate that works as a backing sheet and serves to provide a low cost method for correcting the thickness of a printing plate without reducing the magnetic force of the magnet type printing cylinder. Specifically, it may be in the form of a printing plate precursor assembly that includes (a) the waterless offset lithographic printing plate precursor according to the present invention and (b) a laminate having at least a paramagnetic sheet and a ferromagnetic substrate. It may also suitable to use a printing plate precursor assembly that includes (a) a waterless offset lithographic printing plate prepared by producing an image area on the waterless offset lithographic printing plate precursor according to the present invention and (b) a laminate having at least a paramagnetic sheet and a ferromagnetic substrate. It may be suitable to use either a single paramagnetic sheet or a plurality of such sheets, but in the case of using a plurality thereof, they should be arranged side by side rather than one on top of another. Such a backing sheet is inserted between a magnet type printing cylinder and the waterless offset lithographic printing plate according to the present invention in such a manner that the magnet type printing cylinder, which has a ferromagnetic body, is in contact with the ferromagnetic substrate of the laminate whereas the ferromagnetic substrate of the waterless offset lithographic printing plate according to the present invention is in contact with the magnetic surface of the paramagnetic sheet. There are no particular limitations on the paramagnetic sheet as long as it is a sheet having a magnetic force, and useful examples include generally known magnetic sheets magnetized with neodymium, ferrite, etc.

### EXAMPLES

The present invention is described in more detail below with reference to Examples.

### [Example 1]

A waterless offset lithographic printing plate precursor 1 was prepared by the procedure described below. A primer layer composition solution as described below is spread over a degreased iron substrate with a thickness of 0.30 mm (Hi-Top T-4CA, manufactured by Toyo Kohan Co., Ltd., having a saturation magnetization 2.2 tesla as determined by the method specified in JIS C 2501: 2019, a Rockwell hardness HR30TSm of 61 as determined by the method specified in JIS Z 2245: 2016, and a yield point Yp of 468 MPa as determined by the method specified in JIS Z 2241: 2011), followed by drying at 200°C for 120 seconds to form a primer layer with a thickness of 6.0 µm. Here, the primer layer composition solution was prepared by stirring and mixing the following components at room temperature.

### <Primer layer composition solution>

(a) epoxy resin: EPICOAT^{®} 1010 (manufactured by Japan Epoxy Resin Co., Ltd.): 35 parts by mass
(b) polyurethane: Sanprene^{®} LQ-T1331D (manufactured by Sanyo Chemical Industries Ltd., solid content: 20 mass%): 375 parts by mass
(c) aluminum chelate: aluminum chelate ALCH-TR (manufactured by Kawaken Fine Chemicals Co., Ltd.): 10 parts by mass
(d) leveling agent: Disparlon^{®} LC951 (manufactured by Kusumoto Chemicals Ltd., solid content: 10 mass%): 1 part by mass
(e) titanium oxide: N,N-dimethyl formamide dispersion liquid of Tipaque^{®} CR-50 (manufactured by Ishihara Sangyo Co., Ltd.) (titanium oxide 50 mass%): 60 parts by mass
(f) N,N-dimethyl formamide: 730 parts by mass
(g) methyl ethyl ketone: 250 parts by mass

Subsequently, the following heat-sensitive layer composition solution was spread over the primer layer and heated for drying at 140°C for 120 seconds to form a heat-sensitive layer with a thickness of 1.4 µm. Here, the heat-sensitive layer composition solution was prepared by stirring and mixing the following components at room temperature.

### <Heat-sensitive layer composition solution)

(a) infrared absorbing dye: PROJET 825LDI (manufactured by Avecia): 20 parts by mass
(b) organic complex compound: titanium-n-butoxide bis(acetylacetonate): Na̅cem^{®} Titanium (manufactured by Nihon Kagaku Sangyo Co., Ltd., concentration: 73 mass%, containing 27 mass% n-butanol as solvent): 25 parts by mass
(c) phenol formaldehyde novolac resin: Sumilite Resin^{®} PR53195 (manufactured by Sumitomo Bakelite Co., Ltd.): 88 parts by mass
(d) polyurethane: Sanprene^{®} LQ-T1331D (manufactured by Sanyo Chemical Industries Ltd., solid content: 20 mass%): 25 parts by mass
(e) tetrahydrofuran: 480 parts by mass
(f) diethylene glycol monomethyl ether: 150 parts by mass
(g) ethanol: 180 parts by mass

Subsequently, a silicone rubber layer composition solution that had been prepared immediately before application was spread over the heat-sensitive layer and heated at 140°C for 110 seconds to form a silicone rubber layer with a thickness of 3.8 µm (a weight based thickness of 3.7 g/m²), thereby providing a waterless offset lithographic printing plate precursor. Here, the silicone rubber layer composition solution was prepared by stirring and mixing the following components at room temperature.

### <Silicone rubber layer composition solution>

(a) α,ω-dihydroxypolydimethyl siloxane: DMS-S51 (weight average molecular weight 139,000, manufactured by Gelest, Inc.): 100 parts by mass
(b) tetrakis(methylethyl ketoximino)silane: 12 parts by mass
(c) vinyl tris(methylethyl ketoxyimino)silane: 3.0 parts by mass
(e) dibutyltin diacetate : 0.030 parts by mass
(f) isoparaffin based hydrocarbon solvent, Isopar^{®} E (manufactured by Exxon Mobil Corporation): 900 parts by mass

A layered plate as prepared above was laminated with, as a cover film, a polypropylene film with a thickness of 6.5 µm (Torayfan, manufactured by Toray Industries, Inc.) using a calender roller to provide a waterless offset lithographic printing plate precursor 1.

### [Comparative Example 1]

Except for replacing the degreased iron substrate with a thickness of 0.30 mm (Hi-Top T-4CA, manufactured by Toyo Kohan Co., Ltd.), which was used as the substrate, with a degreased aluminum substrate with a thickness of 0.30 mm (alloy number: 1050, temper: H18, manufactured by Mitsubishi Aluminum Co., Ltd., saturation magnetization: less than 0.1 tesla) and using a primer layer drying period of 90 seconds, a heat-sensitive layer drying period of 90 seconds, and a silicone rubber layer drying period of 80 seconds, the same procedure as in Example 1 was carried out to provide a waterless offset lithographic printing plate precursor 2. Since no yield phenomenon occurs in the aluminum substrate used in Comparative example 1, 0.2% yield strength associated with the transition from the elastic region to the plastic region is substituted, but its value is 150 MPa, which is obviously smaller as compared with the strength of the iron substrate used in Example 1. Its Rockwell hardness was smaller than the lower measurement limit and was not measurable.

### [Example 2] to [Example 5]

Except for replacing the degreased iron substrate with a thickness of 0.30 mm (Hi-Top T-4CA, manufactured by Toyo Kohan Co., Ltd.), which was used as the substrate, with iron substrates as specified in Tables 1 and 2, the same procedure as in Example 1 was carried out to provide a waterless offset lithographic printing plate precursors 3 to 6. These iron substrates had a saturation magnetization of 2.2 tesla.

### <Production of waterless offset lithographic printing plate>

The waterless offset lithographic printing plate precursors prepared in Examples 1 to 5 and Comparative example 1 were exposed using a exposure machine for CTP (PlateRite FX870II, manufactured by SCREEN Graphic Solutions Co., Ltd.) under the condition of an exposure energy of 178 mJ/cm² (drum rotating speed: 420 rpm). For creating exposed image areas, halftone gradations of AM 150 lines/inch, AM 175 lines/inch, AM 200 lines/inch, AM 230 lines/inch, AM 280 lines/inch, and FM20 were used. After removing the cover film, each precursor was allowed to pass at a speed of 30 cm/min through an automatic developing machine (TWL-1160F, manufactured by Toray Industries, Inc.) using CP-X (manufactured by Toray Industries, Inc.) as pre-treatment liquid, tap water as developer, and PA-1 (manufactured by Toray Industries, Inc.) as post-treatment liquid to provide waterless offset lithographic printing plates 1 to 6.

### [Comparative Example 2]

### <Production of resin letterpress printing plate>

Torelief WS83HK2 (manufactured by Toray Industries, Inc.) was adopted as resin letterpress printing plate precursor having a iron substrate with a saturation magnetization of 2.1 tesla (Rockwell hardness HR30TSm: 55, yield point Yp: 270 MPa), and the entire surface was exposed (exposure: 2,400 mJ/cm²) under atmospheric pressure through the cover film using a plate making machine (DX-A3, manufactured by Takano Co., Ltd.) equipped with a 20 watt chemical lamp (FL20SBL-360, manufactured by Mitsubishi Electric Osram Ltd.) to achieve crosslinking over the entire photosensitive layer. Then, after removing the cover film, the crosslinked photosensitive layer was subjected to patterned laser exposure using a laser engraving machine (Adflex Direct 250L, manufactured by Comtex Co., Ltd.) to engrave the photosensitive layer. The engraving conditions included a surface speed of 1,000 cm/second, a laser scanning range of 10 µm, a TOP power of 10%, a BOTTOM power of 100%, and a relief shoulder width of 0.3 mm. The image used for engraving had halftone gradations of AM 133 lines/inch or AM 150 lines/inch.

Subsequently, it was rinsed with tap water at 25°C for 30 seconds using a plate making machine DX-A3, and then dried for 10 minutes using a hot air drier set to 60°C. The entire surface was exposed again (exposure: 2,400 mJ/cm²) under atmospheric pressure to provide a resin letterpress printing plate.

### <Evaluation for mounting on printing cylinder 1>

A magnet type printing cylinder (MMC8-ENOC MODULAR Magnetic Cylinder, manufactured by T. D. Wight, Inc., having a maximum magnetic force of 0.14 tesla as measured with gaussmeter) and a clamp type printing cylinder (C1-ENOC-CLSR Speed Clamp Cylinder, manufactured by T. D. Wight, Inc., having a maximum magnetic force of 0.01 tesla as measured with gaussmeter) were adopted to perform an evaluation for mounting on a printing cylinder. Both printing cylinders had the same size with a diameter of 125 mm, a circumference of 394 mm, and a cylinder length of 17.8 mm. The waterless offset lithographic printing plates 1 to 6 (Examples 1 to 5, Comparative example 1) prepared above and the resin letterpress printing plate of Torelief WS83HK2 (manufactured by Toray Industries, Inc.) (Comparative example 2) were cut to a size of 175 mm x 356 mm to provide samples to be used for the evaluation, which were in the form of precursors patterned and deprived of the cover films.

The plates of Examples 1 to 5 and Comparative example 2 had substrates of ferromagnetic iron and therefore, they were strongly fixed and mounted on magnet type printing cylinders by magnetic force, whereas the plate of Comparative example 1 had a substrate of aluminum, which is a diamagnetic material, and failed to be mounted on a magnet type printing cylinder. In the case of mounting on clamp type printing cylinders, on the other hand, printing plates are fixed mechanically by means of clamps and accordingly, all of the above printing plates were mounted successfully on printing cylinders.

Nevertheless, the waterless offset lithographic printing plate 6 of Example 5 was partly broken when dismounted from a magnet type printing cylinder. This was because the iron substrate had a Rockwell hardness HR30TSm of as low as 55 and was not sufficiently resistant to bending. Compared with this, although having a Rockwell hardness HR30TSm of 55, which is as small as that of the waterless offset lithographic printing plate 6 of Example 5, the resin letterpress printing plate of Comparative example 2 did not easily suffer bending because it was protected by an adhesive layer and a nearly 0.5 mm thick resin layer formed on the iron substrate.

### <Evaluation for mounting on printing cylinder 2>

For an evaluation for mounting on a printing cylinder, an insertion type printing cylinder (APS, manufactured by I. Mer Co., Ltd.) was adopted. After removing the cover film, each of the precursors prepared in Examples 1 to 5 and Comparative examples 1 and 2 was shaped by bending the edges of the plate, and the bent parts were inserted into a specially designed attachment to cause the printing plate precursor to form a hollow tube. Insertion test was performed to examine whether each printing plate precursor in the form of a hollow tube was able to be mounted smoothly on an insertion type printing cylinder, and results showed that the printing plate precursors prepared in Examples 1 to 5 and Comparative example 2, which had iron substrates, were able to be smoothly inserted for mounting and dismounted, whereas the waterless offset lithographic printing plate precursor 2 prepared in Comparative example 1, which had an aluminum substrate, was difficult to mount and dismount since the aluminum substrate rubbed against the insertion type printing cylinder and generated fine aluminum powder to cause resistance.

### <Durability evaluation>

A printing cylinder fitted with a printing plate as described above was attached to a printing test machine, and blankets required for printing on 12 cans were attached to the blanket wheel. Then, the printing plate and the blanket were adjusted to a nip width of 6 mm, and the printing cylinder and the blanket wheel were rotated at a rate of 600 cans/minute for 12 hours. Each of the waterless offset lithographic printing plates 1 and 3 to 6 and the resin letterpress printing plate of Examples 1 to 5 and Comparative example 2 were separately mounted to a magnet type printing cylinder, and the waterless offset lithographic printing plate 2 of Comparative example 1 was mounted on a clamp type printing cylinder. Test results showed that all printing plates had durability for printing on at least 430,000 cans without detachment of a printing plate from the printing cylinder or damage to a printing plate. As their rotation was continued for additional 88 hours (a total of 100 hours, which corresponded to printing on 3,600,000 cans), the waterless offset lithographic printing plates 1 and 3 to 6 of Examples 1 to 5 and the resin letterpress printing plate of Comparative example 2, which had iron substrates, were free of damage, but the waterless offset lithographic printing plate 2 of Comparative example 1, which had an aluminum substrate, was found to suffer abrasion or scraping on the aluminum substrate in clamping portions or plate edges.

### <Durability evaluation 2>

Pins with a size of 2 mm x 2 mm were attached to magnet type printing cylinders while pinholes with a size of 2 mm x 2 mm were formed in the printing plates of Examples 1 to 5 and Comparative example 2, and an evaluation was performed in the same way as in <Durability evaluation> described above. The conditions of each pinhole were inspected after printing on 430,000 cans, and it was found that the printing plates were strongly fixed without suffering a shift in position, although pinholes were slightly damaged in only the printing plates of Example 5 and Comparative example 2. This was thought to be because the yield point Yp, which represents the strength of the substrate, was small. The printing plates of Examples 1 to 4 were further rotated for additional 88 hours (a total of 100 hours, which corresponded to printing on 3,600,000 cans), and it was found that the printing plates were strongly fixed without suffering a shift in position, although pinholes were slightly damaged in only the printing plate of Example 2.

### < Evaluation for reproducibility of halftone dot printing>

In the same way as in <Durability evaluation>, a printing cylinder fitted with a printing plate was attached to a printing test machine, and blankets required for printing on 12 cans were attached to the blanket wheel. A mandrel was attached to the mandrel wheel, and the plate cylinder, blanket wheel, and mandrel wheel were rotated to perform printing with black ink on the curved surfaces of two-piece cans placed on the mandrel. The halftone gradation in the surface pattern on each printed can was inspected, and patterns of different resolutions were evaluated in terms of the range of reproducible printing of halftone dots.

As seen from Tables 1 and 2, the waterless offset lithographic printing plates 1 to 6 of Example 1 to 5 and Comparative example 1 showed high print reproducibility over a wide range of halftone dots even at high resolutions, and in particular, fine patterns with small area rates were printed successfully. On the other hand, the resin letterpress printing plate of Comparative example 2 showed high print reproducibility only over a narrow range of images and was found to be unsuitable for printing of high-resolution patterns such as photographs.

### [Example 6]

For the present invention, a laminate composed of a paramagnetic sheet and a ferromagnetic substrate can be used as a backing sheet to be put on a waterless offset lithographic printing plate. A magnetic sheet with a thickness of 0.45 mm (magnet type: neodymium, magnetization method: anisotropic, manufactured by Magtec. Co., Ltd., maximum magnetic force: 0.12 tesla as measured with gaussmeter), which was adopted as paramagnetic sheet, and a steel sheet with a thickness of 0.05 mm (ferromagnetic material, saturation magnetization: 2.2 tesla) were combined together using a double-sided adhesive tape with a thickness of 0.05 mm in such a manner that the magnetized surface of the magnetic sheet was on the opposite side to the adhered surface, thereby providing a laminate (total thickness: 0.55 mm). This laminate was put over the surface of a magnet type printing cylinder (MMC8-ENOC MODULAR Magnetic Cylinder, manufactured by T. D. Wight, Inc., maximum magnetic force: 0.14 tesla as measured with a gaussmeter) in such a manner that the magnetic sheet formed the outer face, and one of the printing plates of Examples 1 to 5 was mounted thereon. As a result, the surface of the laminate, i.e. the backing sheet, maintained a maximum magnetic force of 0.15 tesla as measured with a gaussmeter and served to strongly fix the lithographic printing plates of Examples 1 to 5.

**[Table 1]**

| | | | Example 1 | Comparative example 1 | Example 2 | Example 3 |
|---|---|---|---|---|---|---|
| Plate used | printing plate precursor | | waterless offset lithographic printing plate precursor 1 | waterless offset lithographic printing plate precursor 2 | waterless offset lithographic printing plate precursor 3 | waterless offset lithographic printing plate precursor 4 |
| | substrate | material | iron Hi-Top T-4CA | aluminum 1050-H18 | iron Cansuper T-4CA | iron Cansuper T-5CA |
| | | thickness [mm] | 0.30 | 0.30 | 0.26 | 0.23 |
| | | Rockwell hardness HR30TSm | 61 | - | 62 | 66 |
| | | yield point Yp [MPa] | 468 | (0.2% yield strength: 150) | 320 | 464 |
| | printing plate | | waterless offset lithographic printing plate 1 | waterless offset lithographic printing plate 2 | waterless offset lithographic printing plate 3 | waterless offset lithographic printing plate 4 |
| Evaluation for mounting on printing cylinder | magnet type printing cylinder: mounting | | good (mountinq possible) | inferior (mounting impossible) | good (mounting possible) | good (mounting possible) |
| | magnet type printing cylinder: dismounting | | good (no bending of plate) | - | good (no bending of plate) | good (no bending of plate) |
| | clamp type printing cylinder: mounting | | good (mounting possible) | good (mounting possible) | good (mounting possible) | good (mounting possible) |
| | insertion type printing cylinder: mounting and dismounting | | good (mounting possible) | inferior (insertion difficult) | good (mounting possible) | good (mounting possible) |
| Durability evaluation | magnet type printing cylinder | | good (durable against 12-hour continuous printing) | - | good (durable against 12-hour continuous printing) | good (durable against 12-hour continuous printing) |
| | clamp type printing cylinder | | - | good (durable against 12-hour continuous printing) | - | - |
| Durability evaluation 2 | magnet type printing cylinder with pins | | good (durable against 12-hour continuous printing) | - | good (durable against 12-hour continuous printing) | good (durable against 12-hour continuous printing) |
| Evaluation for halftone dot reproducibility | resolution: AM 133 line/inch | | 1% to 98% | 1% to 98% | 1% to 98% | 1% to 98% |
| | resolution: AM 150 line/inch | | 1% to 98% | 1% to 98% | 1% to 98% | 1% to 98% |
| | resolution: AM 175 line/inch | | 1% to 98% | 1% to 98% | 1% to 98% | 1% to 98% |
| | resolution: AM 200 line/inch | | 2% to 98% | 2% to 98% | 2% to 98% | 2% to 98% |
| | resolution: AM 230 line/inch | | 3% to 98% | 3% to 98% | 3% to 98% | 3% to 98% |
| | resolution: AM 280 line/inch | | 5% to 98% | 5% to 98% | 5% to 98% | 5% to 98% |
| | resolution: FM20 | | 5% to 98% | 5% to 98% | 5% to 98% | 5% to 98% |

**[Table 2]**

| | | | Example 4 | Example 5 | Comparative example 2 |
|---|---|---|---|---|---|
| Plate used | printing plate precursor | | waterless offset lithographic printing plate precursor 5 | waterless offset lithographic printing plate precursor 6 | resin letterpress printing plate precursor |
| | substrate | material | Cansuper DR - 9 | iron Cansuper T-2.5CA | iron |
| | | thickness [mm] | 0.23 | 0.25 | 0.25 |
| | | Rockwell hardness HR30TSm | 76 | 55 | 55 |
| | | yield point Yp [MPa] | 600 | 285 | 270 |
| | printing plate | | waterless offset lithographic printing plate 5 | waterless offset lithographic printing plate 6 | resin letterpress printing plate |
| Evaluation for mounting on printing cylinder | magnet type printing cylinder: mounting | | good (mounting possible) | good (mounting possible) | good (mounting possible) |
| | magnet type printing cylinder: dismounting | | good (no bending of plate) | fair (bending of plate) | good (no bending of plate) |
| | clamp type printing cylinder: mounting | | good (mountinq possible) | good (mounting possible) | good (mounting possible) |
| | insertion type printing cylinder: mounting and dismounting | | good (mounting possible) | good (mounting possible) | good (mounting possible) |
| Durability evaluation | magnet type printing cylinder | | good (durable against 12-hour continuous printing) | good (durable against 12-hour continuous printing) | good (durable against 12-hour continuous printing) |
| | clamp type printing cylinder | | - | - | - |
| Durability evaluation 2 | magnet type printing cylinder with pins | | good (durable against 12-hour continuous printing) | fair (durable against 12-hour continuous printing, but suffering slight damage to pinholes) | fair (durable against 12-hour continuous printing, but suffering slight damage to pinholes) |
| Evaluation for halftone dot reproducibility | resolution: AM 133 line/inch | | 1% to 98% | 1% to 98% | 10% to 98% |
| | resolution: AM 150 line/inch | | 1% to 98% | 1% to 98% | 20% to 98% |
| | resolution: AM 175 line/inch | | 1% to 98% | 1% to 98% | - |
| | resolution: AM 200 line/inch | | 2% to 98% | 2% to 98% | - |
| | resolution: AM 230 line/inch | | 3% to 98% | 3% to 98% | - |
| | resolution: AM 280 line/inch | | 5% to 98% | 5% to 98% | - |
| | resolution: FM20 | | 5% to 98% | 5% to 98% | - |

## Claims

1. A waterless offset lithographic printing plate precursor comprising at least a heat-sensitive layer and a silicone rubber layer disposed on a substrate, the substrate being of a ferromagnetic material.

2. A waterless offset lithographic printing plate precursor as set forth in claim 1, wherein the ferromagnetic substrate has a saturation magnetization in the range of 0.3 tesla to 10 tesla.

3. A waterless offset lithographic printing plate precursor as set forth in either claim 1 or 2, wherein the ferromagnetic substrate is of a material selected from the group consisting of iron, cobalt, nickel, alloys thereof, and oxides thereof.

4. A waterless offset lithographic printing plate precursor as set forth in any one of claims 1 to 3, wherein the ferromagnetic substrate has a Rockwell hardness HR30TSm in the range of 53 to 80.

5. A waterless offset lithographic printing plate precursor as set forth in one of claims 1 to 3, wherein the ferromagnetic substrate has a yield point Yp in the range of 300 MPa to 2.0 GPa.

6. A waterless offset lithographic printing plate precursor as set forth in one of claims 1 to 5, designed for printing on two-piece cans or printing on tubes.

7. A waterless offset lithographic printing plate precursor as set forth in any one of claims 1 to 6, wherein the silicone rubber layer has a weight based thickness in the range of 3.4 to 10.0 g/m².

8. A waterless offset lithographic printing plate precursor as set forth in any one of claims 1 to 7, mounted on a paramagnetic body having a maximum magnetic force of 0.10 to 1.00 tesla by the action of a magnetic force.

9. A production method for a waterless offset lithographic printing plate comprising the following step (1) and step (2):
step (1): a laser beam is applied to a waterless offset lithographic printing plate precursor as set forth in any one of claims 1 to 8, and
step (2): after the step (1), an image area is produced by removing the silicone rubber layer in the portion exposed to a laser beam.

10. A production method for a waterless offset lithographic printing plate as set forth in claim 9, further comprising at least either one of the step (i) and the step (ii):
step (i): a pre-treatment step performed before the step (2) in order to treat the laser-exposed portion of the silicone rubber layer to make it brittle, and
step (ii): a post-treatment step performed after the step (2) in order to color the image area deprived of the silicone rubber layer.

11. A waterless offset lithographic printing plate prepared by forming an image area on a waterless offset lithographic printing plate precursor as set forth in any one of claims 1 to 8, and mounted on a paramagnetic body having a maximum magnetic force of 0.10 to 1.00 tesla by the action of a magnetic force.

12. A printing plate precursor assembly comprising a stack of:
(a) a waterless offset lithographic printing plate precursor as set forth in any one of claims 1 to 8, and
(b) a laminate having at least a paramagnetic sheet and a ferromagnetic substrate.

13. A printing plate assembly comprising a stack of:
(a) a waterless offset lithographic printing plate prepared by forming an image area on a waterless offset lithographic printing plate precursor as set forth in any one of claims 1 to 8, and
(b) a laminate having at least a paramagnetic sheet and a ferromagnetic substrate.

14. A laminate comprising at least a paramagnetic sheet and a ferromagnetic substrate and designed for correcting the thickness of a printing plate mountable on a magnet type printing cylinder.
